Europäisches Patentamt

European Patent Office

Office européen des brevets

(19)

(11) Veröffentlichungsnummer: **0 184 018**
**B1**

(12) **EUROPÄISCHE PATENTSCHRIFT**

(45) Veröffentlichungstag der Patentschrift: **23.01.91**

(51) Int. Cl.⁵: **H 03 D 3/00**

(21) Anmeldenummer: **85114166.3**

(22) Anmeldetag: **07.11.85**

(54) Demodulator für digitale Empfänger.

(30) Priorität: **06.12.84 DE 3444449**

(43) Veröffentlichungstag der Anmeldung:
**11.06.86 Patentblatt 86/24**

(45) Bekanntmachung des Hinweises auf die
Patenterteilung:
**23.01.91 Patentblatt 91/04**

(84) Benannte Vertragsstaaten:
**DE FR NL**

(56) Entgegenhaltungen:
**EP-A-0 080 014**
**EP-A-0 201 758**

**ARCHIV FÜR ELEKTRONIK UND
UBERTRAGUNGSTECHNIK, Band 36, Nr. 7/8,
Juli/August 1982, Seiten 292-298, C. Hirzel
Verlag, Stuttgart, DE; K.D. KAMMEYER: "Ein
Verfahren zur digitalen Demodulation
frequenzmodulierter Signale"**

(73) Patentinhaber: **Blaupunkt-Werke GmbH
Robert-Bosch-Strasse 200
D-3200 Hildesheim (DE)**

(72) Erfinder: **Kammeyer, Karl Dirk, Prof. Dr.-Ing.
Lange Trift 13a
D-4790 Paderborn (DE)**

(56) Entgegenhaltungen:
**ARCHIV FÜR ELEKTRONIK UND
UBERTRAGUNGSTECHNIK, Band 33, Nr. 11,
November 1979, Seiten 425-431, C. Hirzel
Verlag, Stuttgart, DE; H. SCHENK: "Entwurf von
Sende- und Empfangsfiltern für den Einsatz in
digitalen Modems"**

## Beschreibung

### Stand der Technik

Die Erfindung geht aus von einem Demodulator nach der Gattung des Hauptanspruchs. Aus der EP—A1—80 014 ist bereits ein digitaler Demodulator für frequenzmodulierte Signale bekannt. Der bekannte Demodulator weist einen breitbandigen analogen Bandpass auf, dem ein Analog-Digital-Wandler nachgeschaltet ist. Nach den digitalen Multiplikatoren sind Tiefpassfilter geschaltet, die das eigentliche Nutzsignal ausfiltern. In einer nachfolgenden Schaltung werden die so gewonnenen digitalen Signale aufbereitet. Bei einem praktischen Einsatz dieser Struktur ergeben sich jedoch Schwierigkeiten bezüglich der Dynamikanforderungen an den Analog-Digital-Wandler. Ist nämlich die Vorfilterbandbreite deutlich größer als die eigentliche ZF-Bandbreite, so ist nicht auszuschließen, daß in das Band neben dem Nutzsender eine Reihe von Nachbarsendern fällt, die im Pegel erheblich über dem Nutzsender liegen können. Für ein einwandfreies Arbeiten des Analog-Digital-Wandlers ist jedoch der Maximalwert des Gesamtsignals zugrundezulegen, so daß der Analog-Digital-Wandler diese Dynamik verkraften muß. Um nun auch schwache Sender neben einem starken Sender selektieren zu können, ist es beim Stand der Technik erforderlich, Analog-Digital-Wandler mit einer hohen Auflösung einzusetzen, was jedoch in Anbetracht des schnellen erforderlichen Zeitverhaltens Schwierigkeiten bereitet. Die bekannten digitalen Demodulatoren sind daher gegenüber neben starken Sendern angeordneten schwachen Sendern unempfindlich oder aber aufgrund des zu betreibenden Aufwandes bei der Analog-Digital-Wandlung nur mit großem Aufwand realisierbar.

### Vorteile der Erfindung

Der erfindungsgemäße Demodulator mit den kennzeichnenden Merkmalen des Hauptanspruchs hat damgegenüber den Vorteil, daß durch die Anwendung schmalbandiger Vorfilter verhindert wird, daß neben dem Nutzsignal weitere Nachbarsender ins Band des analogen Vorfilters fallen. Anstelle des Tiefpasses der bekannten digitalen Demodulatoren tritt nunmehr ein Entzerrernetzwerk, das die Phasen- und Dämpfungsverzerrungen des schmalbandigen Vorfilters behebt. Da nun Störungen durch starke Sender in der Nähe eines schwachen Senders nicht auftreten können, ist es möglich, die Dynamikanforderungen bezüglich des Nutzsignals zu reduzieren. Die Wortlänge des Analog-Digital-Wandlers ist daher stark reduzierbar. Als weiterer Vorteil ist anzusehen, daß aufgrund der geringeren Bandbreite des zu verarbeitenden Signales die Abtastfrequenz des Analog-Digital-Wandlers weiter zu reduzieren ist.

Durch die in den Unteransprüchen aufgeführten Maßnahmen sind vorteilhafte Weiterbildungen und Verbesserungen des im Hauptanspruch angegebenen Demodulators möglich. Vorteilhaft ist es, die Kombination des Bandpasses mit den nichtrekursiven Filtern so auszubilden, daß ein minimales Fehlerquadrat auftritt. Dadurch wird erreicht, daß die verbleibenden, nur mit erheblichem Aufwand zu beseitigenden Verzerrungen minimal werden. Günstig ist es ebenfalls, die Entzerrerkoeffizienten der nichtrekursiven Filter in einem Speicher abzulegen und diese dem verwendeten Bandpass anzupassen. Dadurch ist es möglich, beispielsweise durch Auswechseln des Speicherbausteines das Entzerrerverhalten dem verwendeten Bandpass anzupassen, wenn beispielsweise bei der Demodulatorfertigung für verschiedene Zwecke unterschiedliche Bandpässe verwendet werden. Weiterhin ist es vorteilhaft, auch bei der Verwendung gleicher Bandpässe die bei der Herstellung der Bandpässe auftretenden Toleranzen dadurch auszugleichen, daß für jeden Bandpass individuell eine Anpassung der Filterkoeffizienten erfolgt. Dadurch ist es möglich, eine gleichbleibende hohe Qualität der so hergestellten Demodulatoren zu erzielen.

Weiterhin ist es günstig, die Berechnung der Koeffizienten durch Bildung des minimalen Fehlerquadrates in regelmäßigen Abständen oder beim Einschalten des Demodulators vorzunehmen und die ermittelten Koeffizienten in den Speicher einzugeben.

Dadurch wird ein adaptives Verhalten des Entzerrernetzwerkes erreicht, so daß beispielsweise Alterungserscheinungen des Bandpasses und eine damit verbundene Änderung der technischen Daten durch eine entsprechende Korrektur des digitalen Entzerrernetzwerkes ausgeglichen werden.

Vorteilhaft ist es auch, die nichtrekursiven Filter zur Unterdrückung des Mehrwegeempfanges einzusetzen. Hier zu sind lediglich die Filterkoeffizienten in Abhängigkeit von der Phase und der Stärke der Reflexion entsprechend anzupassen. Eine wesentliche Vereinfachung der nichtrekurziven Filter ergibt sich dann, wenn lediglich einfache Reflexionen betrechtet werden. Dann wird ein Großteil der Koeffizienten zu Null, so daß sich der Schaltungsaufwand für die nichtrekursiven Filter erheblich reduziert.

### Zeichnung

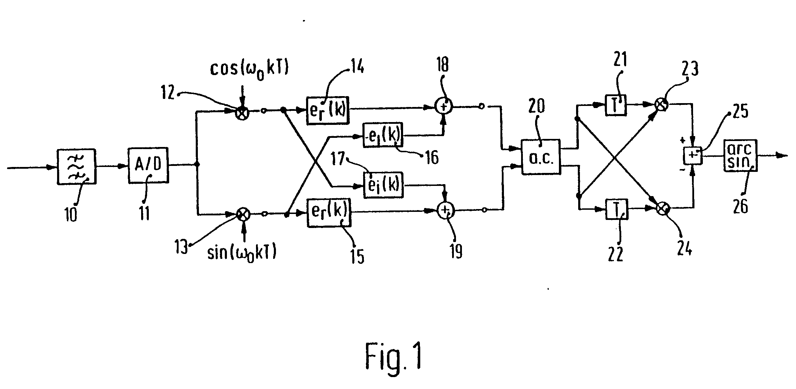

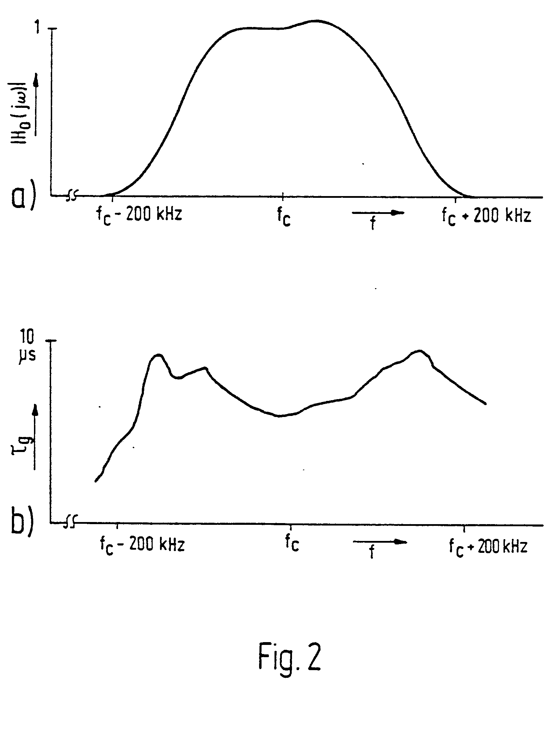

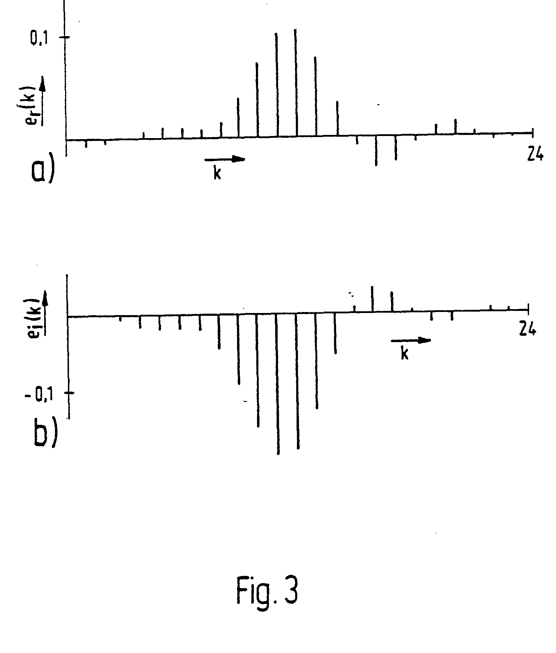

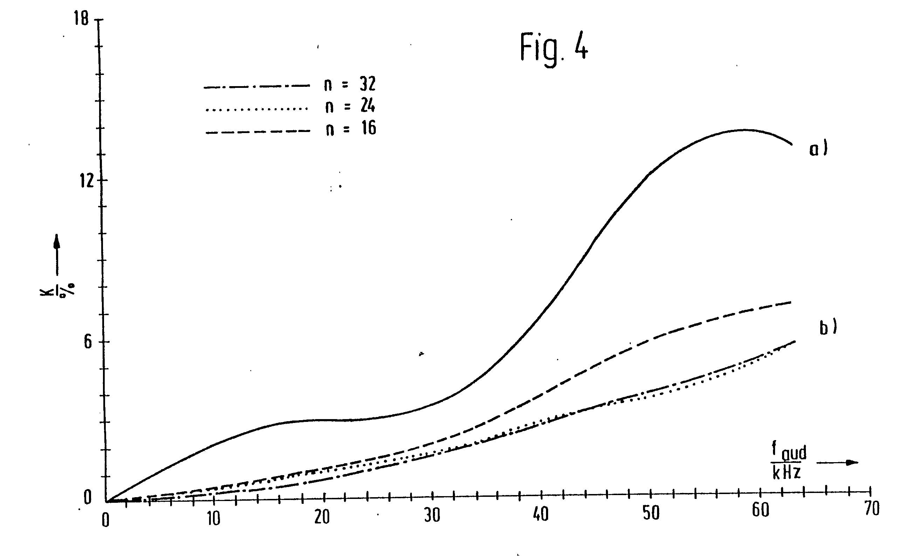

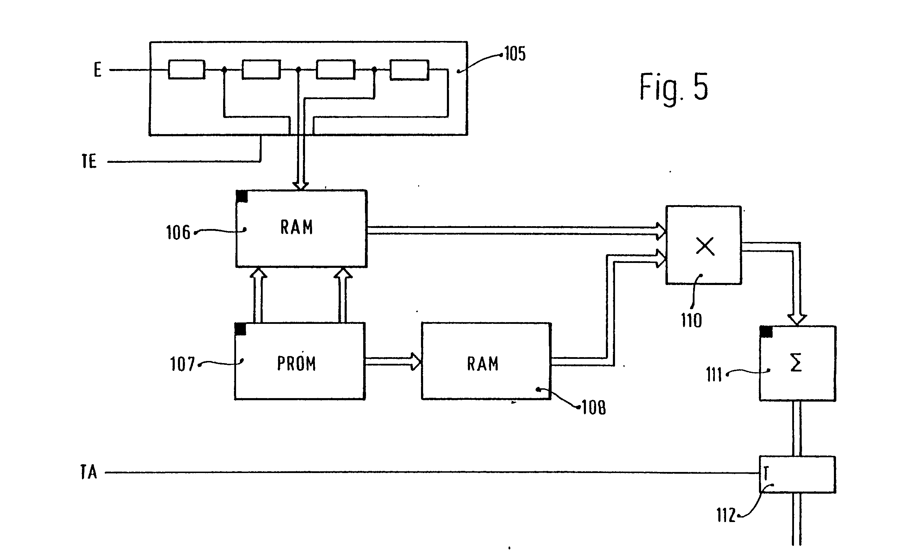

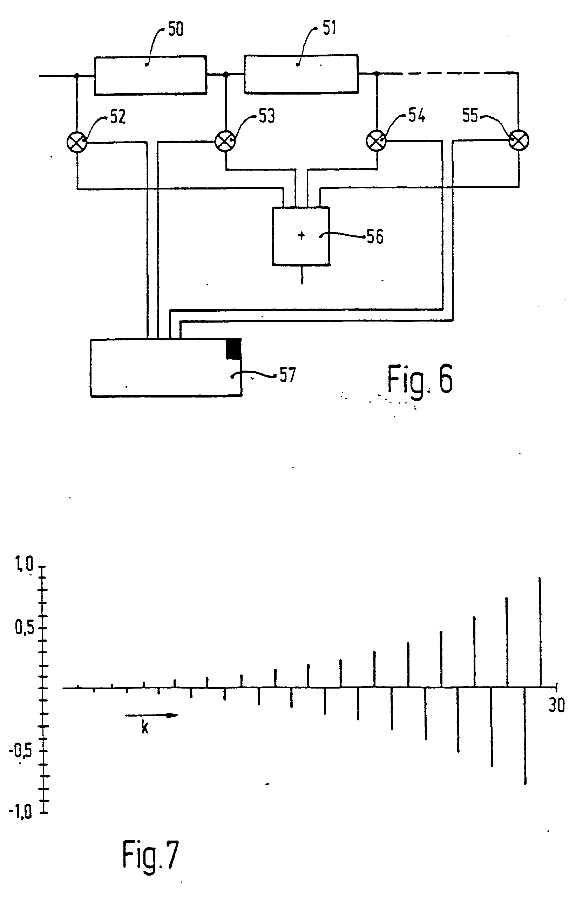

Ein Ausführungsbeispiel der Erfindung ist in der Zeichnung dargestellt und in der nachfolgenden Beschreibung näher erläutert. Es zeigen Figur 1 einen digitalen Empfänger nach der Erfindung, Figur 2 den Betragsfrequenzgang und die Gruppenlaufzeit eines handelsüblichen Keramikfilters, Figur 3 ein Beispiel für die Wahl der Koeffizienten zur Entzerrung eines Filters nach Figur 2, Figur 4 ein Daigramm zur Erläuterung der Verbesserung des Übertragungsverhaltens in Abhängigkeit von der Zahl der Filterkoeffizienten, Figur 5 ein Ausführungsbeispiel eines nichtrekursiven Filters, Figur 6 ein vereinfachtes nichtrekursives Filters zur Reduzierung von empfangenen Einfachreflexionen und Figur 7 ein Beispiel für die Wahl der Koeffizienten zur Ausblendung der Mehrwegeempfangssignale.

Beschreibung des Ausführungsbeispiels

In der europäischen Patentanmeldung EP—A1 80 014 wird ein digitaler Demodulator mit einer analogen Vorfilterung vorgeschalegen, um eine subharmonische Abtastung des Ausgangssignals der ZF-Stufe zu ermöglichen. Dort sind die Zusammenhänge zwischen der Vorfilterbandbreite und der erforderlichen Abtastfrequenz aufgezeigt. Das Ziel ist dabei, einmal eine wirksame Reduktion der Abtastfrequenz durch entsprechend gering gewählte Vorfilterbandbreiten zu erreichen, zum anderen aber von hinreichend breiten analogen Vorfiltern auszugehen, so daß das später digital herauszufilternde Signal nicht durch die ungünstigen Eigenschaften der Analogfilter in Phase und Amplitudengang verzerrt wird. Als Kompromiß ist hier eine Vorfilterbandbreite vorgeschlagen, die wesentlich größer ist als die Bandbreite des zu empfangenden Signals. Die dort niedergelegten grundsätzlichen Gedanken zur digitalen Demodulation sind in der o.g. Patentanmeldung ausführlich erläutert. Bei einem praktischen Einsatz der dort gezeigten Struktur ergeben sich Schwierigkeiten bezüglich der Dynamikanforderungen an den Analog-Digital-Umsetzer.

Wird nälich die Vorfilterbandbreite deutlich größer als die eigentliche ZF-Bandreite angesetzt, so ist der Fall nicht auszuschließen, daß in dieses Band neben dem Nutzsender eine Reihe von Nachbarsendern fällt, die im Pegel erheblich über dem Nutzsender liegen können. Dies trifft insbesondere dann zu, wenn sich der Empfangsort, beispielsweise bei Fahrzeugen, ständig ändert. Vor der Verarbeitung der Signale sind daher Analog-Digital-Wandler notwendig, die eine hinreichende Dynamikreserve aufweisen und daher relativ große Wortlängen verarbeiten müssen.

Eine schmalbandige ZF-Filterung, nun durch das analoge Vorfilter, bringt jedoch große Phasen- und Dämpfungsverzerrungen mit sich, die ausgeglichen werden müssen. Dies geschieht mittels eines digitalen Entzerrers, der anstelle des Tiefpaßpaares des bekannten Demodulators tritt. Dieser digitale Entzerrer hat nun nicht mehr die Aufgabe der Senderselektion sonderen der Kompensation der nichtidealen Eigenschaften das analogen Vorfilters.

Das Blockschaltbild eines digitalen Empfängers mit Entzerrernetzwerk zeigt die Figur 1. Das analoge Zwischenfrequenzsignal kommt zu einem schmalbandigen Filter 10, das als Bandpass ausgebildet ist. Dem analogen Filter 10 folgt ein Analog-Digital-Wandler 11. An den digitalen Ausgang des Analog-Digital-Wandlers 11 sind digitale Multiplikatoren 12 und 13 angeschlossen, wobei im Multiplizierer 12 die Multiplikation mit einer Kosinusfunktion mit der nach der Abtastung vorliegenden Trägerfrequenz fo, während im Multiplizierer 13 die Multiplikation mit einer Sinusfunktion gleicher Frequenz erfolgt. Dem Multiplizierer 12 folgt ein nichtrekursives Filter 14 und ein nichtrekursives Filter 17. Der Ausgang des nichtrekursiven Filters 14 führt zu einem Addierer 18, während der Ausgang des nichtrekursiven Filters 17 zu einem Addierer 19 führt. An Multiplizierer 13 sind ebenfalls zwei nichtrekursive Filter 15 und 16 angeschlossen, wobei der Ausgang des nichtrekursiven Filters 15 an den weiteren Eingang des Addierer 19 und der Ausgang des nichtrekursiven Filters 16 an einen weiteren Eingang des Addierers 18 angechlossen ist. Die Ausgänge der digitalen Addierer 18 und 19 führen zu einer Amplitudenregelschaltung 20, die in bekannter Art und Weise aufgebaut ist und z.B. in der europäischen Patentanmeldung EP—A1 80 014 ausführlich beschrieben ist. Das Ausgangssignal der Amplitudenregelschaltung 20 führt im einen Zeig zu einem Zeitglied 21 und im anderen Zweig zu einem Zeitglied 22. Die Zeitglieder 21 und 22 führen jeweils zu einem Multiplizierer 23 und 24, dem weiterhin das nicht verzögerte Signal des anderen Zweigs zugeführt ist. Die digitalen Ausgangssignale der Multiplizierer 23 und 24 führen zu einem Addierer 25, wobei das Ausgangssignal des Multiplizierers 23 additiv und das Ausgangssignal des Multiplizierer 24 subtraktiv dem Addierer 25 zugeführt ist. Dem Addierer 25 folgt eine Arcus-Sinus-Tafel 26. Am Ausgang der Arcus-Sinus-Tafel 26 ist das niederfrequente digitale NF-Signal abgreifbar.

Die Schaltungsanordnung mit den Verzögerungsgliedern 21 und 22, den Multiplizierern 23 und 24, dem Addierer 25 und der Arcus-Sinus-Tafel 26 sind in der oben erwähnten Patentanmeldung bereits ausführlich beschrieben worden, so daß ein näheres Eingehen auf diese Teile des digitalen Demodulators nicht erforderlich ist.

Die Wirkungsweise der nichtrekursiven Filter 14, 15, 16 und 17 sowie ihr konkreter Aufbau sei anhand der folgenden Figuren näher erläutert.

Von den nichtrekursiven Filtern besitzen die Filter 14 und 15 die Impulsantwort $e_r(k)$, während die anderen beiden rekursiven Filter 16 und 17 die Impulsantwort $e_i(k)$ bzw. $-e_i(k)$ besitzen. Ausführungsbeispiele für nicht rekursive Filter finden sich beispielsweise in dem Buch H. W. Schüssler, Digitale Systeme zur Signalverarbeitung, Springer-Verlag, Berlin 1973. Auf ein Beispiel wird im übrigen im weiteren kurz eingegangen.

Die Koeffizienten der digitalen Entzerrer $e_r(k)$ und $e_i(k)$ müssen so entworfen werden, daß die Hintereinanderschaltung des analogen Bandpasses 10 und des Entzerrers die gleiche Wirkung hat wie das optimierte Tiefpasspaar allein, das bei dem digitalen Empfänger nach dem Stand der Technik Verwendung findet. Da bei der Aufstellung des Gleichungssystemes für die Entwicklung der Koeffizienten die Zahl der Gleichungen die Zahl der Koeffizienten überlicherweise übersteigt, ist die Lösung im Sinne eines minimalen Fehlerquadrates zu lösen, d.h. die Koeffizienten sind so zu wählen, daß die Impulsantwort des Gesamtsystems diejenige eines optimierten ZF-Tiefpasses möglichst optimal approximiert. Die Lösungsansätze im Sinne eines minimalen Fehlerquadrates sind per se bekannt und beispielsweise in dem Artikel H. Schenk, Entwurf von Sende- und Empfangsfiltern für den Einsatz in digitale Modems, Archiv für elektrische Übertragung Nr. 33, 1979, Seite 425 bis 431 beschrieben.

An einem Beispiel soll die Funktion der Entzerrungsschaltung näher erläutert werden. Figur 2a zeigt den Betragsfrequenzgang und Figur 2b die Gruppenlaufzeit eines handelsüblichen Keramik-ZF-Filters für den Einsatz in einem Empfänger. Berechnet man aus den ermittelten Werten des Filters das entzerrende Netzwerk, so erhält man die Koeffizientensätze der verschiedenen Entzerrerzweige, wobei im Ausführungsbeispiel je 24 Koeffizienten vorgesehen sind. Figur 3a zeigt dabei beispielhaft Koeffizienten für die nichtrekursiven Filter 14 und 15, während Figur 3b die Koeffizienten für die nichtrekursiven Filter 16 und 17 zeigt. Die sich ergebende Reduktion der nichtlinearen Verzerrungen ist anhand der Figur 4 ersichtlich. Die dabei erzielbare Entzerrung ist davon abhängig, mit wieviel Koeffizienten die Optimierung vorgenommen wird. Die Figur 4a zeigt den Klirrfaktor des demodulierten Signals als Funktion der Frequenz des modulierenden Signals bei einem Frequenzhub von 75 kHz ohne Einsatz eines Entzerrers. Gegenübergestellt sind in der Figur 4b die Klirrfaktorkurven bei Verwendung von Entzerrern mit verschiedener Anzahl von Koeffizienten in jedem Zweig. Beispielhaft sind die Kurven bei 32, 24 und 16 Koeffizienten abgebildet. Man erkennt, daß mit steigender Anzahl von Koeffizienten eine Verbesserung zu erzielen ist, wobei jedoch die Verbesserung mit wachsender Anzahl der Koeffizienten immer geringer wird.

Figur 5 zeigt ein nichtrekursives Filter, wie es beispielsweise für die Filter 14, 15, 16 und 17 Verwendung finden kann. Das Eingangssignal E gelangt zum N-stufigen Schieberegister 105, wobei jeder Schieberegisterplatz mit einem RAM 106 in Verbindung steht. Dieses Schieberegister dient dem Auffangen von Zwischenwerten der Eingangsfolge, wenn—wie in EP—A1—80 014 beschrieben—eine Reduktion der Abtastfrequenz vom Eingang zum Ausgang des nichtrekursiven Filters um den Faktor N stattfindet. Im folgenden wird das Beispiel N=4 gewählt. Das Schieberegister wird durch den Eingangstakt TE getaktet. Der Ausgang von RAM 106 wird zu einem Eingang eines Multiplizierers 110 geführt. Der Ausgang eines weiteren RAM's 108 steht mit einem weiteren Eingang des Multiplizierers 110 in Verbindung. Die Adressierungen von RAM 106 und 108 werden durch ein PROM 107 gesteuert. Der Ausgang des Multiplizierers 110 führt zu einem Summierer 111, der als Akkumulator geschaltet ist, der Ausgang des Summierers 111 führt zu einem Ausgangsschalter 112, an dessen Ausgang des Ausgangssignal abgreifbar ist. Der Ausgangsschalter 112 wird mit dem Takt TA getaktet.

Digitale nichtrekursive Filter sind im wesentlichen dadurch gekennzeichnet, daß die aktuellen Werts sowie Vergangenheitswerte mit den vorgegebenen Koeffizienten multipliziert werden, wobei die Werte der Koeffizienten durch das gewünschte Verhalten der Filter bestimmt sind. Diese multiplizierten Werte werden addiert und stehen am Ausgang des Filters zur Verfügung. Bei den in Figur 5 dargestellten nichtrekursiven Filter ergibt sich noch die Besonderheit der Abtastreduktion. Mit jedem Taktimpuls des Taktes TE wird der am Eingang des Schieberegisters 105 anliegende Wert in das Schieberegister übernommen und der Vergangenheitswert um Eins weitergeschoben. Sind im Ausführungsbeispiel vier Werte eingelesen, so wird der gesamte Inhalt des Schieberegisters 105 in das RAM 106 übernommen und die vier Speicherwerte an vier bestimmten Speicherplätzen des RAM's 106 abgelegt, d.h. es werden die vier ältesten Vergangenheitswerte überschrieben. Danach werden vier weitere Werte in das Schieberegister 105 eingelesen und diese ebenfalls auf anderen Speicherplätzen des RAM 106 abgelegt. Die bereits vorher eingelesenen, entsprechender Anzahl der Koeffizienten in RAM 106 abgespeicherten Werte werden durch die im PROM 107 abgelegte Steuerung nacheinander aufgerufen. Gleichzeitig werden durch das prom 107 in RAM 108 die entsprechenden Koeffizienten aufgerufen Die Ergebnisse des Multiplizierers 110 werden im Akkumulator 111 aufsummiert.

Sollen die Koeffizienten des Entzerrerfilters nach ihrer Speicherung nicht verändert werden, so können diese im PROM 107 abgespeichert sein. In dem Falle entfällt das RAM 108. Ist jedoch eine Veränderung der Koeffizienten zu einer adaptiven Anpassung an das Bandfilter 10 wünschenswert, so ist es zweckmäßig, die Koeffizienten im RAM 108 abzulegen, da sie dort geändert werden können. Der Summenwert wird in das Ausgaberegister 112 eingelesen, wo es während einer Abtasttaktperiode zur Weiterverarbeitung zur Verfügung steht. Die Abtastreduktion ist übrigens nicht zwingend, sondern hier nur beispielhaft aufgeführt. Prinzipiell ist es möglich, der Ausgangs- und den Eingangstakt gleich zu wählen.

Die Koeffizienten, die für das Ausführungsbeispiel der Figur 3 zu entnehmen sind, können fest in das PROM 107 eingespeichert werden, wenn die Eigenschaften des Bandpasses als solche bekannt sind. Ebenfalls ist eine Einspeicherung im PROM 107 möglich, wenn der Bandpass 10 zwar unterschiedlich ist, jedoch mit einer Änderung seiner Daten während der Lebensdauer des Demodulators nicht gerechnet wird. Werden beispielsweise unterschiedliche Bandpässe verwendet, so genügt es, wenn der Speicher 107 der nichtrekursiven Filter 14, 15, 16 und 17 ausgetauscht wird, um die gesamte Schaltungsanordnung an unterschiedliche Bandpässe anzupassen. Weiterhin ist es möglich, den Speicher 107 erst dann fest zu programmieren, wenn der Bandpass 10 bereits in den digitalen Demodulator eingebaut ist. Dadurch ist es möglich, auch bei gleichen Bandpässen individuelle Fertigungsabweichungen zu berücksichtigen und die nichtrekursiven Filter entsprechend zu optimieren.

Im Rahmen des Fertigungsprozesses digitaler Empfänger werden zu diesem Zwecke die Daten der individuellen analogen Vorfilter 10, beispielsweise Betragsfrequenz und Gruppenlaufzeit oder die Impulsantwort in einen Rechner eingelesen. Die Entzerrerkoeffizienten werden nach dem oben beschriebenen Verfahren berechnet und in dem PROM 107 abgespeichert, welches im individuellen Digitalempfänger als Koeffizientenspeicher zum Einsatz kommt. Das Verfahren ist in der vorliegenden Form nicht adaptiv. Es ist aber auch möglich, durch eine automatische Aufnahme der Impulsantwort des analogen Vorfilters, beispielsweise in regelmäßigen Zeitabständen oder beim Einschalten des Gerätes, die Berechnung der Entzerrerdaten mit einem im Gerät befindlichen Mikroprozessor vorzunehmen und die ermittelten Koeffizienten in RAM 108 einzuspeichern. Auf diese Weise können auch langfristige Veränderungen des Bandpasses 10 ausgeglichen werden.

Die beschriebene Entzerrungsschaltungsanordnung kann auch zur Reduktion der nichtlinearen Verzerrungen unter dem Einfluß von Mehrwegempfang benutzt werden. Hierzu müssen lediglich die Stärken der Reflexionen sowie ihre Phasenlagen und die Laufzeitdifferenzen zwischen der direkten Welle und den Reflexionen bekannt sein. In diesem Falle ist die durch Reflexionen gestörte Übertragungsstecker ähnlich wie ein Bandpassfilter zu behandeln, dessen Amplitudengang und Phasenlaufzeit feststeht. Die Dimensionierung der nicht rekursiven Filter erfolgt dann in der gleichen Art und Weise, wie dies zuvor beschrieben worden ist.

Geht man von einer einfachen Reflexion aus, d.h. einer direkten und einer reflektierten Welle, so ergeben sich bezüglich der Ausgestaltung der nichtrekursiven Filter wesentliche Vereinfachungen. Die vereinfacht aufgebaute nichtrekursive Filter, das für die Filter 14, 15, 16 und 17 verwendbar ist, ist in Figur 6 dargestellt. Das Eingangssignal E gelangt zu den Schieberegistern 50, 51 und gegebenenfalls zu weiteren Schieberegistern. Das Eingangssignal wird weiterhin zu einem Multiplizierer 52 geführt. Zwischen den Schieberegistern sind weitere Multiplizierer angeschlossen, beispielsweise zwischen den Schieberegistern 50 und 51 der Multiplizierer 53, nach dem Schieberegister 51 der Multiplizierer 54 und am Ende der Schieberegisterkette der Multiplizierer 55. Als weitere Eingangsgröße der Multiplizierer dienen die Koeffizienten, die die Eigenschaften des nichtrekursiven Filters bestimmen und die im Speicher 57 niedergelegt sind. Die Ausgänge der Multiplizierer 52 bis 54 sind zu jeweils einem Eingang eines Addierers 56 geführt, an dessen Ausgang das gefilterte Signal abgreifbar ist. Die Schieberegister 50 und 51 und weitere Schieberegister machen sich die Eigenschaft zunutze, daß im Falle der Einfachreflexion die meisten Koeffizienten 0 sind. Verschieden von 0 sind nur die Koeffizienten, die Vielfachen der Laufzeitdifferenz zwischen direkter und reflektierender Welle dividiert durch das Abtastintervall entsprechen. Werden die Schieberegister 50 und 51 daher mit einer bestimmten Abtastrate getaktet, so muß jedes einzelne Verzögerungsglied der Schieberegisterkette so viele Speicherplätze haben, daß das Abtastintervall multipliziert mit der Zahl der Speicherplätze gerade die Laufzeitdifferenz ergeben. Ändert sich die Laufzeitdifferenz zwischen der direkten und der reflektierten Welle, so ist dies einfach dadurch zu berücksichtigen, daß bei den Schieberegistern 50 und 51 Speicherplätze zu- oder abgeschaltet werden. Die Werte der Koeffizienten selbst hängen nun nur von der Stärke der Reflexion und deren Phasenlage ab. nicht von der Laufzeitdifferenz. Diese schlägt sich ausschließlich wie beschrieben in der Strukturierung des Zustandsspeichers des Entzerrers nieder. Ein Beispiel für die Wahl der Koeffizienten ist aus Figur 7 ersichtlich. Es est erkennbar, daß die Koeffizienten in dem hier betrachteten Falle, in dem die Amplitude der reflektierten Welle um den Faktor 1, 11 größer ist als diejenige der direkten Welle, eine exponentiell ansteigende Charakteristik aufweisen. Ist die Amplitude der reflektierten Welle kleiner als die der direkten Welle, so ergibt sich eine exponentiell abfallende Charakteristik. Der Fall der Gleichheit beider Amplituden ist mit dem hier beschriebenen Verfahren grundsätzlich nicht zu behandeln. In dem in Figur 7 gezeigten speziellen Beispiel sind die Koeffizienten der Filter 16 und 17 gleich 0, da zwischen der reflektierten Welle und der direkten Welle eine Phasendrehung von 0 angenommen ist.

## Patentansprüche

1. Demodulator für frequenzmodulierte Signale, die in einem Funkempfänger an der Zwischenfrequenzstufe abnehmbar sind und über einen analogen Bandpaß (10) und einen Analog/Digital-Wandler (11) in digitaler Form in zwei parallelen Zweigen, in den Basisbandbereich transformiert werden und im Basisbandbereich jeweils über digitale nichtrekursive Tiefpaßfilter (14 bis 19) und eine Eindeutigkeitsschaltung (20 bis 26) geleitet werden, dadurch gekennzeichnet, daß der Bandpaß (10) schmelbandig mit einer Bandbreite von etwa ±200 kHz ausgeführt ist und daß die nichtrekursiven Filter (14 bis 19) als Entzerrernetzwerke ausgebildet sind, welche die Phasen- und Dämpfungsverzerrungen des schmalbandigen, analogen Bandpaßfilters, der diesen vorgeschalteten Eingangsstufen und Antenne und des Übertragungsweges zur Antenne beheben.

2. Demodulator nach Anspruch 1, dadurch gekennzeichnet, daß in der Serienschaltung der Bandpaß (10) und die nichtrekursiven Filter (14 bis 19) so aufeinander abgestimmt sind, daß in der resultierenden Impulsantwort am Ausgang des Demodulators ein minimales Fehlerquadrat auftritt.

3. Demodulator nach Anspruch 1 oder 2, dadurch gekennzeichnet, daß die Entzerrekoeffizienten der nichtrekursiven Filter (14, 15, 16, 17) in einem Speicher (107) abgelegt sind und dem verwendeten Bandpass (10) angepaßt sind.

4. Demodulator nach Anspruch 3, dadurch gekennzeichnet, daß die Anpassung für jeden Bandpass (10) individuell erfolgt.

5. Demodulator nach Anspruch 3 oder 4, dadurch gekennzeichnet, daß die Bildung des minimalen Fehlerquadrates in regelmäßigen Abständen oder beim Einschalten des Demodula-

tors erfolgt und die ermittelten Koeffizienten in den Speicher (108) eingegeben sind.

6. Demodulator nach Anspurch 6, dadurch gekennzeichnet, daß die nichtrekursiven Filter aus Teilschieberegistern (50, 51) gebildet sind, deren Ausgänge in Multiplizierer (52, 53, 54, 55) mit den Koeffizienten multipliziert werden und daß die Ausgangssignale der Multiplizierer einem Addierer (56) zugeführt sind.

7. Demodulator nach Anspruch 7, dadurch gekennzeichnet, daß die Zahl der Schieberegisterplätze eines jeden Verzögerungsgliedes (50, 51) der Schieberegisterkette so gewählt sind, daß ihre Zahl multipliziert mit dem Abtastintervall der Laufzeitverzögerung zwischen direkt empfangenen Signal und reflektiertem Signal entspricht.

**Revendications**

1. Démodulateur pour des signaux à modulation de fréquence qui sont fournis par un récepteur radio à l'étage de fréquence intermédiaire et sont transmis par un filtre passe bande analogique (10) et un convertisseur analogique/numérique (11), sous forme numérique à deux branches parallèles dans lesquelles on transforme la plage de la bande de base et on transmet les signaux dans cette plage de bande de base par un filtre passe bas numérique (14—19) non récurrent et un circuit de non équivocité (20—26), démodulateur caraactérisé en ce que le filtre à bande passante (10) est à bande étroite avec une largeur de bande d'environ±200 kHz et les filtres non récurrents (14 à 19) sont des circuits de correction de distorsion qui suppriment les distorsions de phase et d'atténuation du filtre à bande passante analogique étroite des étages d'entrée en amont, de l'antenne et du chemin de transmission vers l'antenne.

2. Démodulateur selon la revendication 1, caractérisé en ce que le montage en série formé du filtre passe bande (10) et des filtres non récurrents (14 à 19) sont définis réciproquement pour que la réponse impulsionnelle résultante arrive à la sortie du démodulateur avec une erreur quadratique minimale.

3. Démodulateur selon la revendication 1 ou 2, caractérisé en ce que les coefficients de correction de distorsion des filtres non récurrents (14, 15, 16, 17) sont inscrits dans une mémoire (107) et sont adaptés au filtre passe bande (20) utilisé.

4. Démodulateur selon la revendication 3, caractérisé en ce que l'adaptation de chaque filtre à bande passante (10) se fait de manière individuelle.

5. Démodulateur selon la revendication 3 ou 4, caractérisé en ce qu'on forme à intervalles réguliers l'erreur quadratique minimale ou encore lors du branchement du démodulateur et on introduit les coefficients ainsi obtenus dans la mémoire (108).

6. Démodulateur selon la revendication 5, caractérisé en ce que les filtres non récurrents se composent de registres à décalage partiel (50, 51) dont les sorties sont appliquées à des multiplicateurs (52, 53, 54, 55) pour être multipliées par des coefficients et les signaux de sortie des multiplicateurs sont appliqués à un additionneur (56).

7. Démodulateur selon la revendication 6, caractérisé en ce que le nombre des emplacements de registres à décalage de chaque élément de temporisation (50, 51) de la chaîne de registres à décalage sont choisis pour que leur nombre multiplié par l'intervalle de détection corresponde au retard de parcours entre le signal reçu directement et le signal réfléchi.

**Claims**

1. Demodulator for frequency-modulated signals which can be picked up at the intermediate-frequency stage in a radio receiver and are transformed into the baseband domain in digital form in two parallel branches via an analog band-pass filter (10) and an analog/digital converter (11) and in the baseband domain are in each case conducted via digital non-recursive low-pass filters (14 to 19) and a uniqueness circuit (20 to 26), characterized in that the band-pass filter (10) is constructed to be narrow-band with a band width of about ±200 kHz and in that the non-recursive filters (14 to 19) are constructed as equalizer networks which eliminate the phase and attenuation distortions of the narrow-band analog band-pass filter, of the input stages and antenna preceding the latter and of the transmission path to the antenna.

2. Demodulator according to Claim 1, characterized in that in the series circuit, the band-pass filter (10) and the non-recursive filters (14 to 19) are matched to one another in such a manner that a minimum square of errors occurs in the resulting pulse response at the output of the demodulator.

3. Demodulator according to Claim 1 or 2, characterized in that the equalizer coefficients of the non-recursive filters (14, 15, 16, 17) are stored in a memory (107) and are matched to the band-pass filter (10) used.

4. Demodulator according to Claim 3, characterized in that the matching is effected individually for each band-pass filter (10).

5. Demodulator according to Claims 3 or 4, characterized in that the minimum square of errors is formed at regular intervals or when the demodulator is switched on and the coefficients determined are entered into the memory (108).

6. Demodulator according to Claim 5, characterized in that the non-recursive filters are formed of partshift registers (50, 51) the outputs of which are multiplied by the coefficients in multipliers (52, 53, 54, 55) and in that the output signals of the multipliers are supplied to an adder (56).

7. Demodulator according to Claim 6, characterized in that the number of shift register locations of each delay section (50, 51) of the shift register chain is selected in such a manner that its number, multiplied by the sampling interval, corresponds to the transit delay between the directly received signal and the reflected signal.

Fig.1

Fig. 2

Fig. 3

Fig. 4

Fig. 5

Fig. 6

Fig.7